(19) Europäisches Patentamt
European Patent Office
Office européen des brevets

(11) **EP 3 642 639 B1**

(12) **EUROPÄISCHE PATENTSCHRIFT**

(45) Veröffentlichungstag und Bekanntmachung des Hinweises auf die Patenterteilung:
**28.04.2021 Patentblatt 2021/17**

(21) Anmeldenummer: **18733823.1**

(22) Anmeldetag: **19.06.2018**

(51) Int Cl.:
*G01R 31/52* *(2020.01)*     *G01R 31/50* *(2020.01)*
*G01R 31/327* *(2006.01)*

(86) Internationale Anmeldenummer:
**PCT/EP2018/066160**

(87) Internationale Veröffentlichungsnummer:
**WO 2018/234259 (27.12.2018 Gazette 2018/52)**

(54) **SCHALTUNGSANORDNUNG ZUR AUSWERTUNG VON ZUMINDEST ZWEI SCHALTZUSTÄNDEN EINES BETÄTIGUNGSELEMENTES, VERFAHREN ZUM BETREIBEN EINER SCHALTUNGSANORDNUNG SOWIE SCHALTVORRICHTUNG**

CIRCUIT ARRANGEMENT FOR EVALUATING AT LEAST TWO SWITCHING STATES OF AN ACTUATING ELEMENT, METHOD FOR OPERATING A CIRCUIT ARRANGEMENT AND SWITCHING DEVICE

AGENCEMENT DE CIRCUIT DESTINÉ À ÉVALUER AU MOINS DEUX ÉTATS DE COMMUTATION D'UN ÉLÉMENT D'ACTIONNEMENT, PROCÉDÉ DE FONCTIONNEMENT D'UN AGENCEMENT DE CIRCUIT ET UN DISPOSITIF DE COMMUTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.06.2017 DE 102017113905**

(43) Veröffentlichungstag der Anmeldung:
**29.04.2020 Patentblatt 2020/18**

(73) Patentinhaber: **Valeo Schalter und Sensoren GmbH**
**74321 Bietigheim-Bissingen (DE)**

(72) Erfinder:
• **MUELLER, Stefan**
**74321 Bietigheim-Bissingen (DE)**
• **MACK, Raphael**
**74321 Bietigheim-Bissingen (DE)**

(74) Vertreter: **Pothmann, Karsten**
**Valeo Schalter und Sensoren GmbH**
**CDA-IP**
**Laiernstraße 12**
**74321 Bietigheim-Bissingen (DE)**

(56) Entgegenhaltungen:
DE-A1-102006 038 375     DE-A1-102009 056 283
DE-A1-102010 048 750     DE-A1-102014 117 417

**Beschreibung**

Die Erfindung betrifft eine Schaltungsanordnung zur Auswertung von zumindest zwei Schaltzuständen eines Betätigungselements aufweisend ein bewegbares, mit dem Betätigungselement verbindbares Kontaktmittel, eine erste Auswerteschaltung mit einem ersten Spannungsteiler, welcher erste Kontenpunkte sowie einen ersten Abgriff zum Abgreifen eines ersten Ausgangssignals der ersten Auswerteschaltung aufweist, zumindest eine zweite Auswerteschaltung, welcher zweite Kontenpunkte sowie einen zweiten Abgriff zum Abgreifen eines zweiten Ausgangssignals der zweiten Auswerteschaltung aufweist, erste Kontaktflächen, welche jeweils mit einem der ersten Knotenpunkte elektrisch verbunden sind, und zweite Kontaktflächen, welche jeweils mit einem der zweiten Knotenpunkte elektrisch verbunden sind, wobei über das bewegbare Kontaktmittel in Abhängigkeit von dem Schaltzustand des Betätigungselementes zumindest eine der ersten Kontaktflächen und/oder zumindest eine der zweiten Kontaktflächen mit einem vorbestimmten Bezugspotential elektrisch verbindbar sind.. Die Erfindung betrifft außerdem ein Verfahren zum Betreiben einer Schaltungsanordnung sowie eine Schaltvorrichtung mit einer Schaltungsanordnung und einem Betätigungselement.

Schaltungsanordnungen zur Auswertung von Schaltzuständen bzw. Stellungen von Betätigungselementen sind bereits aus dem Stand der Technik bekannt. Die Druckschrift DE102009056283 A1 offenbart eine solche Schaltungsanordnung. Z Solche Betätigungselemente können in einem Kraftfahrzeug vorgesehen sein und als Schalter, beispielsweise als Lenkstockschalter, ausgebildet sein, welche zur Fahrtrichtungsanzeige oder auch zu Betätigung einer Scheibenwischeranlage des Kraftfahrzeugs eingesetzt werden können. Auch ist es bekannt, die Auswertung des Schaltzustandes des Betätigungselements digital oder analog auszuführen. Dazu weisen die bereits bekannten Schaltungsanordnungen ein bewegliches Kontaktmittel auf, welches mechanisch mit dem Betätigungselement verbunden ist. Über dieses Kontaktmittel des Betätigungselementes werden in Abhängigkeit von dem jeweiligen Schaltzustand des Betätigungselementes verschiedene Knotenpunkte einer Auswerteschaltung der Schaltungsanordnung miteinander und/oder mit einem Bezugspotential verbunden. Dadurch ändert sich in Abhängigkeit von der Schalterstellung ein Ausgangssignal der Auswerteschaltung.

Bei der analogen Auswertung der Schaltzustände kann es beispielsweise aufgrund einer sich verschlechternden Kontaktqualität zwischen dem Kontaktmittel und mit dem Kontaktmittel zusammenwirkenden Kontaktflächen der Auswerteschaltung zu einer fehlerhaften Auswertung kommen. Eine Verschlechterung der Kontaktqualität kann beispielsweise durch Materialverschleppung, Kontaktverschmutzung oder Kontaktkorrosion entstehen und dazu führen, dass sich ein Kontaktwiderstand zwischen dem Kontaktmittel und der Kontaktfläche verändert und dadurch eine Veränderung des Ausgangssignals bewirkt wird. Wenn dieses veränderte Ausgangssignal einer anderen, als der tatsächlich vorliegenden Schalterstellung zugeordnet ist, so kann es zu einer fehlerhaften Interpretation bzw. Auswertung dieser Schalterstellung kommen. Dies ist insbesondere im Falle von sicherheitskritischen Anwendungen problematisch. Wenn bei einem Schalter eines Fahrtrichtungsanzeiger bzw. Blinkers der Schaltzustand dahingehend fehlinterpretiert wird, dass ein Blinksignal in der anderen als der von dem Fahrer gewählten Richtung ausgegeben wird, so kann es zu einer Gefährdung des Fahrers sowie anderer Verkehrsteilnehmer kommen.

Um die Sicherheit einer Schaltungsanordnung gegenüber Fehlauswertungen zu steigern, schlägt die WO 2008/0173511 A1 vor, die Schaltungsanordnung mit zwei Auswerteschaltungen auszustatten, wobei bestimmte Schaltzustände nur durch die erste Auswerteschaltung und bestimmte Schaltzustände nur durch die zweite Auswerteschaltung ausgewertet werden. Beispielsweise kann die erste Auswerteschaltung im Falle eines Fahrtrichtungsanzeigers nur die mit einer ersten Fahrtrichtung korrespondierenden Schaltzustände und die zweite Auswerteschaltung nur die mit einer zweiten Fahrtrichtung korrespondierenden Schaltzustände erfassen.

Bei dieser Schaltungsanordnung reicht jedoch die Diagnostizierbarkeit und Robustheit gegenüber an der Schaltungsanordnung üblicherweise auftretenden Ausfall-bzw. Fehlerarten nicht mehr aus, insbesondere um die neuesten Anforderungen von Automobilherstellern diesbezüglich zu erfüllen. Beispielsweise können bei der bekannten Schaltungsanordnung Fehler in Form von Kurzschlüssen zwischen zwei mechanisch benachbarten Kontaktflächen nicht sicher erkannt werden. Da die Kontaktflächen jedoch bauartbedingt sehr dicht, das heißt mit kleinem Isolierabstand, nebeneinander angeordnet werden, lassen sich Kurzschlüsse, zum Beispiel durch Abrieb, Betauung, Schmutz oder andere leitende Fremdkörper, nicht mit ausreichender Sicherheit ausschließen. Die Fehlererkennbarkeit ist noch stärker eingeschränkt, wenn ein Kurzschluss zwischen einer Kontaktfläche an der ersten Auswerteschaltung und einer Kontaktfläche an der zweiten Auswerteschaltung auftritt. Darüber hinaus wird die Fehlererkennbarkeit weiter eingeschränkt, wenn nicht nur reine Kurzschlüsse, also Übergangswiderstände mit in etwa 0 Ohm, in Betracht gezogen werden, sondern auch Feinschlüsse, also beliebige parasitäre Übergangswiderstände, zwischen zwei Kontaktflächen.

Es ist Aufgabe der vorliegenden Erfindung, eine besonders zuverlässige Schaltungsanordnung zur Auswertung von Schaltzuständen eines Betätigungselementes zu realisieren, welche hinsichtlich einer Diagnostizierbarkeit von Fehlern optimiert ist.

Diese Aufgabe wird erfindungsgemäß durch eine Schaltungsanordnung, ein Verfahren zum Betreiben einer Schaltungsanordnung sowie eine Schaltvorrichtung gemäß den jeweiligen unabhängigen Ansprüchen gelöst. Vorteilhafte Ausführungsformen der Erfindung sind Gegenstand der abhängigen Ansprüche, der Beschreibung sowie der Figuren.

Bei einem Aspekt einer erfindungsgemäßen Schaltungsanordnung zur Auswertung von zumindest zwei Schaltzuständen eines Betätigungselementes weist diese insbesondere ein bewegbares, mit dem Betätigungselement verbindbares Kontaktmittel, eine erste Auswerteschaltung mit einem ersten Spannungsteiler, welcher erste Kontenpunkte sowie einen ersten Abgriff zum Abgreifen eines ersten Ausgangssignals der ersten Auswerteschaltung aufweist, und zumindest eine zweite Auswerteschaltung mit einem zweiten Spannungsteiler, welcher zweite Kontenpunkte sowie einen zweiten Abgriff zum Abgreifen eines zweiten Ausgangssignals der zweiten Auswerteschaltung aufweist, auf. Insbesondere weist die Schaltungsanordnung außerdem erste Kontaktflächen, welche jeweils mit einem der ersten Knotenpunkte elektrisch verbunden sind, und zweite Kontaktflächen, welche jeweils mit einem der zweiten Knotenpunkte elektrisch verbunden sind, auf, wobei über das bewegbare Kontaktmittel in Abhängigkeit von dem Schaltzustand des Betätigungselementes zumindest eine der ersten Kontaktflächen und/oder zumindest eine der zweiten Kontaktflächen mit einem vorbestimmten Bezugspotential elektrisch verbindbar sind. Insbesondere sind die Auswerteschaltungen separat voneinander anschaltbar und abschaltbar ausgebildet, wobei die Schaltungsanordnung dazu ausgelegt ist, anhand des Ausgangssignals einer angeschalteten Auswerteschaltung den Schaltzustand des Betätigungselementes zu erfassen und anhand des Ausgangssignals einer abgeschalteten Auswerteschaltung eine Fehlerdiagnose der Schaltungsanordnung durchzuführen.

Besonders bevorzugt weist eine Schaltungsanordnung zur Auswertung von zumindest zwei Schaltzuständen eines Betätigungselements ein bewegbares, mit dem Betätigungselement verbindbares Kontaktmittel, eine erste Auswerteschaltung mit einem ersten Spannungsteiler, welcher erste Kontenpunkte sowie einen ersten Abgriff zum Abgreifen eines ersten Ausgangssignals der ersten Auswerteschaltung aufweist, und zumindest eine zweite Auswerteschaltung mit einem zweiten Spannungsteiler, welcher zweite Kontenpunkte sowie einen zweiten Abgriff zum Abgreifen eines zweiten Ausgangssignals der zweiten Auswerteschaltung aufweist, auf. Außerdem weist die Schaltungsanordnung erste Kontaktflächen, welche jeweils mit einem der ersten Knotenpunkte elektrisch verbunden sind, und zweite Kontaktflächen, welche jeweils mit einem der zweiten Knotenpunkte elektrisch verbunden sind, auf, wobei über das bewegbare Kontaktmittel in Abhängigkeit von dem Schaltzustand des Betätigungselementes zumindest eine der ersten Kontaktflächen und/oder zumindest eine der zweiten Kontaktflächen mit einem vorbestimmten Bezugspotential elektrisch verbindbar sind. Darüber hinaus sind die Auswerteschaltungen separat voneinander anschaltbar und abschaltbar ausgebildet, wobei die Schaltungsanordnung dazu ausgelegt ist, anhand des Ausgangssignals einer angeschalteten Auswerteschaltung den Schaltzustand des Betätigungselementes zu erfassen und anhand des Ausgangssignals einer abgeschalteten Auswerteschaltung eine Fehlerdiagnose der Schaltungsanordnung durchzuführen.

Die Schaltungsanordnung kann beispielsweise zum Auswerten des Schaltzustandes bzw. einer Stellung des Betätigungselementes in einem Kraftfahrzeug verwendet werden. Das kraftfahrzeugseitige Betätigungselement kann beispielsweise als ein Schalter in Form von einem Lenkstockschalter ausgebildet sein. Um eine Positionierung des Betätigungselementes in einem von einer das Betätigungselement betätigenden Person gewählten Schaltzustand zu erfassen bzw. auszuwerten, weist die Schaltungsanordnung das Kontaktmittel sowie die Auswerteschaltungen auf. Das Kontaktmittel ist im mechanisch verbundenen Zustand mit dem Betätigungselement insbesondere gemeinsam mit dem Betätigungselement bewegbar. Die Schaltungsanordnung und das Betätigungselement, welches mit dem bewegbaren Kontaktmittel insbesondere mechanisch verbunden ist, können also eine Schaltvorrichtung ausbilden.

Jede Auswerteschaltung umfasst den die jeweiligen Knotenpunkte aufweisenden Spannungsteiler, wobei die Spannungsteiler den jeweiligen Abgriff zum Abgreifen des Ausgangssignals der jeweiligen Auswerteschaltung aufweisen. Die Spannungsteiler weisen dabei vorzugsweise zumindest zwei zueinander in Reihe geschaltet Widerstände, insbesondere ohmsche Widerstände, auf. Zwischen den einzelnen Widerständen sind die Knotenpunkte angeordnet. Der Spannungsteiler kann auch aus anderen spannungsabfallerzeugenden Bauelementen gebildet sein. Die Abgriffe der jeweiligen Spannungsteiler bilden die Ausgangsanschlüsse der Auswerteschaltungen. In einer alternativen Ausführungsform können die Auswerteschaltungen jeweils einen, die Knotenpunkte aufweisenden Stromteiler aufweisen. Die Stromteiler können aus einer Parallelschaltung von Widerständen gebildet sein.

Außerdem weist die Schaltungsanordnung zum Kontaktieren des Kontaktmittels mit den Knotenpunkten der Auswerteschaltungen die Kontaktflächen auf. Die Kontaktflächen sowie das Kontaktmittel sind vorzugsweise jeweils aus einem geeigneten Kontaktwerkstoff ausgebildet, der eine für die vorgesehene Auswertung hinreichend große elektrische Leitfähigkeit aufweist bzw. einen entsprechend geringen Kontaktwiderstand ermöglicht. Durch das Kontaktmittel kann zumindest eine der ersten Kontaktflächen und damit der mit der zumindest einen ersten Kontaktfläche verbundene erste Knotenpunkt der ersten Auswerteschaltung mit dem Bezugspotential verbunden werden. Alternativ oder zusätzlich kann durch das Kontaktmittel zumindest eine der zweiten Kontaktflächen und damit der mit der zumindest einen zweiten Kontaktfläche verbundene zweite Knotenpunkt der zweiten Auswerteschaltung mit dem Bezugspotential verbunden werden. Das Bezugspotential kann beispielsweise ein Massepotential sein.

Wird nun der Schaltzustand bzw. die Schalterstellung des Betätigungselementes geändert, so wird auch die Position des Kontaktmittels geändert. Durch die Positionsänderung des Kontaktmittels kann beispielsweise eine Anzahl bzw. eine Konfiguration der miteinander und mit dem Bezugspotential verbundenen spannungsabfallerzeugenden Bauelemente des ersten Spannungsteilers und/oder eine Konfiguration der miteinander und mit dem Bezugspotential verbundenen spannungsabfallerzeugenden Bauelemente des zweiten Spannungsteilers verändert werden. Anders ausgedrückt kann über denjenigen ersten Knotenpunkt, welcher über das bewegliche Kontaktmittel mit dem Bezugspotential verbunden ist, eine zu dem Schaltzustand des Betätigungselementes korrespondierende Anzahl an spannungsabfallerzeugenden Bauelementen des ersten Spannungsteilers mit dem Bezugspotential verbunden werden und/oder über denjenigen zweiten Knotenpunkt, welcher über das bewegliche Kontaktmittel mit dem Bezugspotential verbunden ist, eine zu dem Schaltzustand des Betätigungselementes korrespondierende Anzahl an spannungsabfallerzeugenden Bauelementen des zweiten Spannungsteilers mit dem Bezugspotential verbunden werden.

Durch die Veränderung der Konfiguration der spannungsabfallerzeugenden Bauelemente des ersten Spannungsteilers ändert sich auch ein erstes Ausgangssignal der ersten Auswerteschaltung. Ebenso ändert sich bei Veränderung der Konfiguration der spannungsabfallerzeugenden Bauelemente des zweiten Spannungsteilers ein zweites Ausgangssignal der zweiten Auswerteschaltung. Die ersten und zweiten Ausgangssignale können ausgewertet werden und im angeschalteten Zustand der Auswerteschaltungen einem entsprechenden Schaltzustand zugeordnet werden.

Dabei kann vorgesehen sein, dass ein erster Schaltzustand oder eine erste Gruppe von Schaltzuständen nur von der ersten Auswerteschaltung erfasst wird und ein zweiter Schaltzustand oder eine zweite Gruppe von Schaltzuständen nur von der zweiten Auswerteschaltung erfasst wird. Beispielsweise kann im Falle eines Fahrtrichtungsanzeigers die erste Auswerteschaltung nur Schaltzustände erfassen, welche einer ersten Fahrtrichtung zugeordnet sind, und die zweite Auswerteschaltung kann nur Schaltzustände erfassen, welche einer zweiten Fahrtrichtung zugeordnet sind. Bei Vorliegen des ersten Schaltzustandes oder eines Schaltzustandes aus der ersten Gruppe werden insbesondere nur die zu dem Schaltzustand korrespondierenden spannungsabfallerzeugenden Bauelemente des ersten Spannungsteilers miteinander und mit dem Bezugspotential verbunden. Es ändert sich also nur das erste Ausgangssignal der ersten Auswerteschaltung. Bei Vorliegen des zweiten Schaltzustandes oder eines Schaltzustandes aus der zweiten Gruppe werden insbesondere hingegen nur die zu dem Schaltzustand korrespondierenden spannungsabfallerzeugenden Bauelemente des zweiten Spannungsteilers miteinander und mit dem Bezugspotential verbunden. Es ändert sich also nur das zweite Ausgangssignal der zweiten Auswerteschaltung.

Es kann aber auch vorgesehen sein, dass jeder Schaltzustand von beiden Auswerteschaltungen erfasst wird. Im Falle des Fahrtrichtungsanzeigers erfasst also jede Auswerteschaltung die Schaltzustände, welche beiden Richtungen zugeordnet sind. Hier ändern sich also bei jedem Schaltzustand beide Ausgangssignale. Somit wird bereits ein hohes Maß an Redundanz erreicht, da beispielsweise ein durch die erste Auswerteschaltung erfasster Schaltzustand mittels der zweiten Auswerteschaltung überprüft bzw. plausibilisiert werden kann.

Probleme ergeben sich aber, wenn Knotenpunkte der Auswerteschaltungen dauerhaft mit einem spannungsführenden Teil verbunden sind, beispielsweise über einen Kurzschluss oder einen Feinschluss, im Folgenden als Schlüsse bezeichnet. Ein solches spannungsführendes Teil kann auch ein Knotenpunkt der jeweils anderen Auswerteschaltung sein. Dann kann es vorkommen, dass eine Auswerteschaltung aufgrund der Verbindung eines ihrer Knotenpunkte mit dem spannungsführenden Teil ein fehlerhaftes Ausgangssignal ausgibt. Dieses Ausgangssignal kann beispielsweise fälschlicherweise einem anderen, nicht dem tatsächlich vorliegenden Schaltzustand des Betätigungselementes entsprechen, sodass das Ausgangssignal fehlinterpretiert wird.

Um einen solchen Fehler diagnostizieren zu können, sind die Auswerteschaltungen separat voneinander schaltbar bzw. zueinander unabhängig schaltbar. Beispielsweise weist die Schaltungsanordnung zumindest zwei Einrichtungen zum separaten Schalten einer Energieversorgung der Auswerteschaltungen auf, wobei eine erste der Einrichtungen dazu ausgelegt ist, die Energieversorgung der ersten Auswerteschaltung zu schalten, und wobei eine zweite der Einrichtungen dazu ausgelegt ist, die Energieversorgung der zweiten Auswerteschaltung zu schalten. Wenn beispielsweise eine Auswerteschaltung angeschaltet ist, so wird sie in einem Erfassungsmodus betrieben, in welchem die Auswerteschaltung den Schaltzustand erfassen kann. Wenn beispielsweise eine Auswerteschaltung abgeschaltet wird, so wird sie einen Diagnosemodus überführt. In diesem Diagnosemodus sollte die abgeschaltete Auswerteschaltung im fehlerlosen Fall ein definiertes Ausgangssignal, beispielsweise eine Ausgangsspannung von 0 V, ausgeben. Wird jedoch ein davon abweichendes Ausgangssignal durch die sich im Diagnosemodus befindliche Auswerteschaltung ausgegeben, so deutet dies auf einen Fehler hin, beispielsweise dass einer der Knotenpunkte über einen Kurzschluss oder einen niederohmigen parasitären Widerstand mit einem spannungsführenden Teil verbunden ist. Dabei kann beispielsweise eine Auswerteschaltung abgeschaltet werden und eine andere Auswerteschaltung angeschaltet werden, sodass die Schaltungsanordnung gleichzeitig den Schaltzustand des Betätigungselementes erfassen und die Fehlerdiagnose durchführen kann.

Aus der Schaltbarkeit der Auswerteschaltungen ergibt sich der Vorteil, dass die Schaltungsanordnung zur Selbstdiagnose ausgelegt ist und die Schaltungsanordnung dadurch besonders sicher gestaltet ist. Somit können Fehler innerhalb der Schaltungsanordnung besonders einfach und zuverlässig erkannt werden und damit der tatsächliche Schaltzustand des Betätigungselements bestimmt werden.

Vorzugsweise weist die Schaltungsanordnung zumindest eine Recheneinheit auf, welche dazu ausgelegt ist, die Ausgangssignale der Auswerteschaltungen auszuwerten, und zumindest eine Steuereinheit auf, welche dazu ausgelegt ist, die Auswerteschaltungen separat voneinander zu schalten. Dabei kann eine Recheneinheit mit zumindest zwei Analogeingängen vorgesehen sein, welche mit einem jeweiligen Abgriff der zumindest zwei Auswerteschaltungen elektrisch verbindbar sind. Es kann aber auch vorgesehen sein, dass eine zu der Anzahl an Auswerteschaltungen korrespondieren Anzahl an Recheneinheiten vorgesehen ist, sodass jeweils eine Recheneinheit mit einer Auswerteschaltung elektrisch verbunden ist. Somit kann ein besonders hohes Maß an Sicherheit bei der Bestimmung der Betätigungselementstellung erreicht werden, da auch Einzelfehler in einer der Recheneinheiten erkannt werden können. Die zumindest eine Steuereinheit ist dazu ausgelegt, die Auswerteschaltungen zu schalten, beispielsweise durch Schalten der entsprechenden Energieversorgungen. Es können beispielsweise vorbestimmte Schaltzyklen für die Steuereinheit hinterlegt sein, welche diese, insbesondere innerhalb eines Messzyklus zur Erfassung eines Schaltzustandes, durchführt.

Besonders bevorzugt weist die Schaltungsanordnung zum Schalten der Auswerteschaltungen zumindest zwei schaltbare Energiequellen zum Bereitstellen einer Energieversorgung für die Auswerteschaltungen auf, wobei die erste Auswerteschaltung mit einer ersten der schaltbaren Energiequellen elektrisch verbunden ist und die zumindest eine zweite Auswerteschaltung mit einer zweiten der schaltbaren Energiequellen elektrisch verbunden ist. Die schaltbaren Energiequellen können beispielsweise schaltbare Spannungsquellen oder schaltbare Stromquellen sein. Dazu sind die Auswerteschaltungen über einen jeweiligen ersten Anschluss mit der jeweiligen schaltbaren Energiequelle verbunden. Jeweilige zweite Anschlüsse der Auswerteschaltungen sind mit einem Bezugspotential verbunden. Das Bezugspotential kann beispielsweise das Massepotential oder ein anderes definiertes Potential sein. Durch die schaltbaren Energiequellen kann das An- und Abschalten der Auswerteschaltungen auf besonders einfache Weise erfolgen.

Alternativ ist es auch möglich zwei separate Schalter für die jeweiligen Auswerteschaltungen bereitzustellen, wobei die zwei separaten Schalter an ein und derselben Energiequelle angeschlossen sind.

In einer Weiterbildung der Erfindung sind die Spannungsteiler über einen jeweiligen Vorwiderstand mit jeweils einer als schaltbare Spannungsquelle ausgebildeten Energiequelle zum Bereitstellen einer Versorgungsspannung für die Auswerteschaltungen oder die Spannungsteiler direkt mit jeweils einer als schaltbare Stromquelle ausgebildeten Energiequelle elektrisch verbunden. Der Vorwiderstand ist ein sogenannter Pull-up-Widerstand. Durch die dem Spannungsteiler in Abhängigkeit von der Betätigungselementstellung des Betätigungselements zugeschalteten Widerstände liegt am Abgriff eine von der Betätigungselementstellung abhängige Ausgangsspannung an, welche besonders einfach ausgewertet und der entsprechenden Betätigungselementstellung zugeordnet werden kann.

Auch kann vorgesehen sein, dass die Schaltungsanordnung zum Schalten der Auswerteschaltungen zumindest zwei steuerbare Schalteinrichtungen aufweist, wobei die erste Auswerteschaltung mit einer ersten der steuerbaren Schalteinrichtungen zum Schalten der ersten Auswerteschaltung an einen Versorgungsanschluss elektrisch verbunden ist, und die zumindest eine zweite Auswerteschaltung mit einer zweiten der steuerbaren Schalteinrichtungen zum Schalten der zweiten Auswerteschaltung an einen Versorgungsanschluss elektrisch verbunden ist. Eine solche steuerbare Schalteinrichtung kann beispielsweise ein Halbleiterschalter sein. Beispielsweise können die ersten Anschlüsse der Auswerteschaltungen mit einem ersten Versorgungsanschluss verbunden sein und die zweiten Anschlüssen der Auswerteschaltungen mit einem zweiten Versorgungsanschluss verbunden sein. An den ersten Versorgungsanschluss kann eine Energiequelle angeschlossen sein, sodass an dem ersten Versorgungsanschluss eine Versorgungsspannung anliegt. Der zweite Versorgungsanschluss kann mit einem Bezugspotential, beispielsweise Masse, verbunden sein. Es kann auch vorgesehen sein, dass jede Auswerteschaltung über die ersten Anschlüsse an einen separaten ersten Versorgungsanschluss mit einer separaten Energiequelle angeschlossen ist. Jeweils einer der beiden Versorgungsanschlüsse, also der erste oder der zweite Versorgungsanschluss, kann über die jeweilige Schalteinrichtung an die Auswerteschaltungen geschaltet werden. Anders ausgedrückt können die Auswerteeinrichtungen entweder separat an den Versorgungsanschluss mit der Energiequelle oder an den Versorgungsanschluss mit dem Bezugspotential angeschlossen werden.

Vorzugsweise weist die Schaltungsanordnung eine mit einer Anzahl an zu erfassenden Schaltzuständen korrespondierende Anzahl an ersten Kontaktflächen und eine mit der Anzahl an zu erfassenden Schaltzuständen korrespondierende Anzahl an zweiten Kontaktflächen auf. Anders ausgedrückt entspricht die Anzahl an ersten Kontaktflächen und die Anzahl an zweiten Kontaktflächen jeweils der Anzahl an zu erfassenden Schaltzuständen des Betätigungselementes. Dabei sind die ersten und zweiten Kontaktflächen insbesondere derart angeordnet, dass in jedem Schaltzustand eine erste und eine zweite Kontaktfläche über das bewegliche Kontaktmittel mit dem Bezugspotential elektrisch verbunden werden. Gemäß dieser Ausführungsform kann jeder Schaltzustand des Betätigungselementes von beiden, sich im angeschalteten Zustand befindlichen Auswerteschaltungen erfasst werden, wodurch in vorteilhafter Weise ein hohes Maß an Redundanz bei der Auswertung des Schaltzustandes erreicht werden kann.

In einer vorteilhaften Weiterbildung der Erfindung ist das bewegliche Kontaktmittel als eine mehrpolige Brücke ausgebildet, welche dazu ausgelegt ist, in Abhängigkeit von dem Schaltzustand des Betätigungselementes zumindest eine der ersten Kontaktflächen und/oder zumindest eine der zweiten Kontaktflächen mit dem Bezugspotential elektrisch zu verbinden. Insbesondere weist die mehrpolige Brücke drei Pole auf, wobei in Abhängigkeit von dem Schaltzustand des Betätigungselementes ein erster Pol mit einer der ersten Kontaktflächen, ein zweiter Pol mit einer mit dem Bezugspotential verbundenen Bezugspotentialfläche und ein dritter Pol mit einer der zweiten Kontaktflächen elektrisch verbindbar ist. Das Kontaktmittel kann zwischen verschiedenen Schaltzuständen, beispielsweise linear oder auf einer Kreisbahn, hin und her bewegt werden. Durch die Bewegung des Kontaktmittels wird in Abhängigkeit von der Position des Kontaktmittels zumindest eine erste und/oder zumindest eine zweite Kontaktfläche über die mehrpolige Brücke mit dem Bezugspotential elektrisch verbunden. Dadurch werden je nach Schaltzustand unterschiedliche, mit den jeweiligen Kontaktflächen verbundene Knotenpunkte der betreffenden Auswerteschaltung mit dem Bezugspotential verbunden. Insbesondere ist der zweite Pol der mehrpoligen Brücke dauerhaft mit der Bezugspotentialfläche verbunden.

Darüber hinaus wäre es alternativ auch möglich die mehrpolige Brücke zweiteilig auszuführen. Das würde bedeuten, dass das bewegliche Kontaktmittel beispielsweise zwei zweipolige Brücken aufweisen kann, so dass die Kontaktflächen der ersten und zweiten Auswerteschaltung mit unterschiedlichen Bezugspotentialflächen verbunden werden können. Die unterschiedlichen Bezugspotentialflächen können unterschiedliche oder gleiche Bezugspotential aufweisen.

Es erweist sich als vorteilhaft, wenn die ersten und zweiten Kontaktflächen sich in Spalten entlang eines Verfahrweges des beweglichen Kontaktmittels erstrecken und dabei insbesondere auf einem gemeinsamen Schaltungsträger angeordnet sind, wobei in einer ersten Spalte abwechselnd erste und zweite Kontaktflächen und in einer zweiten Spalte abwechselnd zweite und erste Kontaktflächen angeordnet sind. Insbesondere ist auf dem gemeinsamen Schaltungsträger zwischen der ersten und der zweiten Spalte eine sich entlang des Verfahrweges erstreckende mit dem Bezugspotential verbundene Bezugspotentialfläche als dritte Spalte angeordnet. Der Schaltungsträger kann beispielsweise eine Leiterplatte bzw. ein PCB ("Printed Circuit Board") sein, auf welchem die Kontaktflächen sowie die Bezugspotentialfläche in Form von elektrisch leitfähigen Flächen bzw. "Pads" angeordnet sein können. Über Leiterbahnen können die ersten und zweiten Kontaktflächen mit den Knotenpunkten der entsprechenden Auswerteschaltung dauerhaft elektrisch verbunden sein. Die über den Verfahrweg ausgebildete Bezugspotentialfläche kann dabei dauerhaft mit dem zweiten Pol des beweglichen Kontaktmittels kontaktiert werden. Solche Kontaktflächen können einfach auf Schaltungsträgern angeordnet werden, wobei die Schaltungsträger besonders kostengünstig und in hoher Stückzahl hergestellt werden können.

Durch die spaltenweise Anordnung der Kontaktflächen, insbesondere mit der Bezugspotentialfläche, ergibt sich eine blockförmige Anordnung der Kontaktflächen sowie der Bezugspotentialfläche. Unter der spaltenweisen Anordnung ist hier die Anordnung der Kontaktflächen entlang einer jeweiligen Linie zu verstehen, wobei die Linie sich entlang des Verfahrweges des beweglichen Kontaktmittels erstreckt. Somit ist natürlich auch die reihenweise Anordnung der Kontaktflächen und der Bezugspotentialfläche bei einem sich in horizontaler Richtung bewegenden Kontaktmittel oder die Anordnung der Kontaktflächen und der Bezugspotentialfläche auf Kreisbahnen bei einem sich entlang einer Kreisbahn bewegenden Kontaktmittel möglich.

Dabei befindet sich die Bezugspotentialfläche insbesondere zwischen den Kontaktflächen der ersten Spalte und den Kontaktflächen der dritten Spalte. Die ersten und zweiten Kontaktflächen der ersten und dritten Spalte sind dabei abwechselnd angeordnet, wobei die ersten und die zweiten Kontaktflächen in der ersten und der dritten Spalte gegenläufig angeordnet sind. Dies bedeutet, dass beispielsweise in einer ersten Zeile der blockförmigen Anordnung eine erste Kontaktfläche, ein Teilbereich der Bezugspotentialfläche sowie eine zweite Kontaktfläche angeordnet sind. In einer darauffolgenden zweiten Zeile sind zuerst eine zweite Kontaktfläche, ein Teilbereich der Bezugspotentialfläche sowie eine erste Kontaktfläche angeordnet, usw. Dadurch wird verhindert, dass zwei zur selben Auswerteschaltung gehörige Kontaktflächen nebeneinander, also mechanisch zueinander benachbart, angeordnet sind. Anders ausgedrückt sind zwei erste Kontaktflächen örtlich immer durch eine zweite Kontaktfläche und/oder die Bezugspotentialfläche voneinander getrennt. Daraus ergibt sich der Vorteil, dass keine schwer detektierbaren Schlüsse zwischen zwei Kontaktflächen derselben Auswerteschaltung auftreten können.

Schlüsse zwischen einer ersten Kontaktfläche und einer zweiten Kontaktfläche, welche bei der abwechselnden Anordnung der ersten und zweiten Kontaktflächen möglich sind, sind jedoch durch die schaltbaren Auswerteschaltungen in vorteilhafter Weise diagnostizierbar. Über einen Schluss ist nämlich die von dem Schluss betroffene Kontaktfläche der abgeschalteten Auswerteschaltung mit der angeschalteten und damit spannungsführenden Auswerteschaltung verbunden.

Diese Verbindung ist anhand des Ausgangssignals der abgeschalteten Auswerteschaltung detektierbar bzw. erkennbar. Die erste Auswerteschaltung kann beispielsweise neben der ersten Spalte angeordnet sein und die zweite Auswerteschaltung neben der dritten Spalte angeordnet sein. Dies bedeutet, dass die Auswerteschaltungen auf einander gegenüberliegenden Seiten des Blockes aufweisend die drei Spalten angeordnet sind. Die Auswerteschaltungen können dabei gegenläufig angeordnet sein. Dies bedeutet, dass beispielsweise die erste Kontaktfläche in der ersten Zeile der Blockes mit einem ersten der ersten Knotenpunkt der ersten Auswerteschaltung verbunden ist, während hingegen die zweite Kontaktfläche in der ersten Zeile mit einem letzten der zweiten Knotenpunkte der zweiten Auswerteschaltung verbunden ist, usw.

Um nun die ersten Kontaktflächen der dritten Spalte mit den entsprechenden ersten Knotenpunkten der ersten Auswerteschaltung sowie die zweiten Kontaktflächen der ersten Spalte mit den entsprechenden zweiten Knotenpunkten der zweiten Auswerteschaltung elektrisch zu verbinden, können entsprechende Leiterbahnen mittels "Vias" bzw. Durchkontaktierungen auf eine Rückseite des Schaltungsträger bzw. auf eine Zwischenlage eines mehrlagigen Schaltungsträgers geführt werden, um von dort aus zu der entsprechenden Auswerteschaltung geführt zu werden. So kann die Schaltungsanordnung besonders platzsparend und kompakt auf dem Schaltungsträger angeordnet werden.

Die Erfindung betrifft auch ein Verfahren zum Betreiben einer erfindungsgemäßen Schaltungsanordnung. Dabei werden während der Erfassung des Schaltzustandes des Betätigungselementes zumindest zwei Schaltzyklen der Schaltungsanordnung durchgeführt. In einem ersten Schaltzyklus wird die erste Auswerteschaltung angeschaltet und die zweite Auswerteschaltung abgeschaltet. Durch die erste Auswerteschaltung wird ein erstes Ausgangssignal und durch die zweite Auswerteschaltung ein zweites Ausgangssignal erfasst. In einem zweiten Schaltzyklus wird die erste Auswerteschaltung abgeschaltet und die zweite Auswerteschaltung angeschaltet. Durch die erste Auswerteschaltung wird ein drittes Ausgangssignal und durch die zweite Auswerteschaltung ein viertes Ausgangssignal erfasst. Der Schaltzustand wird anhand der vier Ausgangssignale bestimmt wird.

Das erste und das vierte Ausgangssignal werden also in einem Erfassungsmodus der angeschalteten Auswerteschaltungen erfasst und sind dabei diejenigen Ausgangssignale, anhand welcher die Schalterstellung des Betätigungselementes ausgewertet werden kann. Das zweite und dritte Ausgangssignal werden in dem Diagnosemodus der abgeschaltete Auswerteschaltungen erfasst. Anhand des zweiten und des dritten Ausgangssignals kann die ausgewertete Schalterstellung überprüft bzw. plausibilisiert werden, indem diese Ausgangssignale zur Fehlerdiagnose ausgewertet werden, so dass beispielsweise Kurzschlüsse zwischen den Kontaktflächen einer Spalte detektiert werden können. Beispielsweise kann davon ausgegangen werden, dass ein Fehler, beispielsweise in Form von einem Kurzschluss, in der Schaltungsanordnung vorliegt, falls das zweite und/oder das dritte Ausgangssignal eine von 0 V verschiedene Ausgangsspannung aufweisen.

In einer vorteilhaften Weiterbildung wird zum Erfassen des Schaltzustandes des Betätigungselementes zumindest ein dritter Schaltzyklus durchgeführt, in welchem die erste und die zweite Auswerteschaltung zeitgleich angeschaltet werden, durch die erste Auswerteschaltung ein fünftes Ausgangssignal erfasst wird und durch die zweite Auswerteschaltung ein sechstes Ausgangssignal erfasst wird, wobei die Schalterstellung anhand der sechs Ausgangssignale bestimmt wird. Unter dem zeitgleichen Anschalten der Auswerteschaltungen ist zu verstehen, dass die Auswerteschaltungen zumindest über einen Zeitraum der Erfassung der jeweiligen Ausgangssignale an den Auswerteschaltungen gemeinsam eingeschaltet sind. Der dritte Schaltzyklus wird vorzugsweise zeitlich vor dem ersten und dem zweiten Schaltzyklus durchgeführt. Der dritte Schaltzyklus kann beispielsweise als ein reiner Messzyklus zum schnellen Erfassen des Schaltzustandes dienen. So kann der Schaltzustand anhand des fünften und des sechsten Ausgangssignals ausgewertet werden. Der Schaltzustand kann plausibilisiert werden, indem durch Vergleich des fünften und des sechsten Ausgangssignals überprüft wird, ob beide Ausgangssignale auf denselben Schaltzustand hindeuten. Falls ja, kann dieser, beispielsweise einer fahrzeugseitigen Steuereinrichtung, kommuniziert werden. Die Steuereinrichtung kann dann ein entsprechendes Signal, beispielsweise das zu der Schalterstellung korrespondierende Blinksignal, generieren. Anschließend können der erste und der zweite Schaltzyklus durchgeführt werden, um eine Fehlerdiagnose in der Schaltungsanordnung durch separates Ausschalten der Auswerteschaltungen durchzuführen. Vorzugsweise wird zum Überprüfen der Schalterstellung ein dreistufiger Plausibilisierungszyklus durchlaufen, wobei in einer ersten Stufe jedes Ausgangssignal separat plausibilisiert wird, in einer zweiten Stufe die miteinander korrespondierenden Ausgangssignale der zumindest zwei Auswerteschaltungen miteinander verglichen und plausibilisiert werden, und in einer dritten Stufe die Ausgangssignale der jeweiligen Schaltzyklen miteinander verglichen und plausibilisiert werden. In der ersten Stufe werden die einzelnen Ausgangssignale separat zueinander, also unabhängig voneinander, ausgewertet. Dies bedeutet beispielsweise, dass überprüft wird, ob das erste, vierte, fünfte und sechste Ausgangssignal, welche in den angeschalteten Zuständen der Auswerteschaltungen erfasst wurden, für sich genommen überhaupt plausible Signalwerte aufweisen, welche zu einer gültigen Schalterstellung korrespondieren. Außerdem wird insbesondere überprüft, ob das zweite und dritte Ausgangssignal, welche in einem ausgeschalteten Zustand der Auswerteschaltung erfasst wurden, auf einen Fehler hindeuten, beispielsweise wenn zumindest eines dieser Ausgangssignale um mehr als einen vorbestimmten Schwellwert von 0 V abweicht.

In der zweiten Stufe werden die zueinander korrespondierenden Ausgangssignale verglichen. Insbesondere werden das erste und das vierte sowie das fünfte und das sechste Ausgangssignal miteinander verglichen, um zu überprüfen, ob diese Ausgangssignale auf dieselbe Schalterstellung hinweisen. Es werden also die Ausgangssignale der zumindest zwei Auswerteschaltungen gegeneinander ausgewertet. In der dritten Stufe werden die Ausgangssignale der verschiedenen Schaltzyklen miteinander verglichen. Es wird also verglichen, ob die jeweilige Auswerteschaltung in denjenigen Schaltzyklen, in welchen sie eingeschaltet war, in etwa die gleichen Ausgangssignale aufweist. Dazu werden beispielsweise das erste und das fünfte sowie das vierte und das sechste Ausgangssignal miteinander verglichen.

Durch dieses dreistufige Verfahren kann auf besonders zuverlässige Weise überprüft werden, ob der ausgewertete Schaltzustand dem tatsächlichen Schaltzustand entspricht. Dies ist insbesondere bei sicherheitskritischen Anwendungen besonders vorteilhaft. Das Verfahren ermöglicht somit eine hohe Sicherheit bei der Auswertung der Schaltzustände des Betätigungselementes.

Eine erfindungsgemäße Schaltvorrichtung umfasst eine erfindungsgemäße Schaltungsanordnung sowie einen Betätigungselement, wobei das Betätigungselement mit dem beweglichen Kontaktmittel der Schaltungsanordnung verbunden ist. Das

Betätigungselement sowie das Kontaktmittel sind insbesondere mechanisch verbunden und gemeinsam bewegbar. Die Schaltvorrichtung ist insbesondere in einem Kraftfahrzeug anordenbar, beispielsweise zum Ausbilden eines Lenkstockschalters des Kraftfahrzeugs.

Die mit Bezug auf die erfindungsgemäße Schaltungsanordnung vorgestellten bevorzugten Ausführungsformen und deren Vorteile gelten entsprechend für das erfindungsgemäße Verfahren sowie für die erfindungsgemäße Schaltvorrichtung.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder abweichen.

Dabei zeigen:

Fig. 1 eine schematische Darstellung einer ersten Ausführungsform einer erfindungsgemäßen Schaltungsanordnung;

Fig. 2 eine schematische Darstellung einer zweiten Ausführungsform einer erfindungsgemäßen Schaltungsanordnung;

Fig. 3 eine schematische Darstellung eines Ablaufes von Schaltzyklen beim Erfassen eines Schaltzustandes eines der Schaltungsanordnung zugeordneten Betätigungselementes.

In den Figuren sind gleiche sowie funktionsgleiche Elemente mit den gleichen Bezugszeichen versehen.

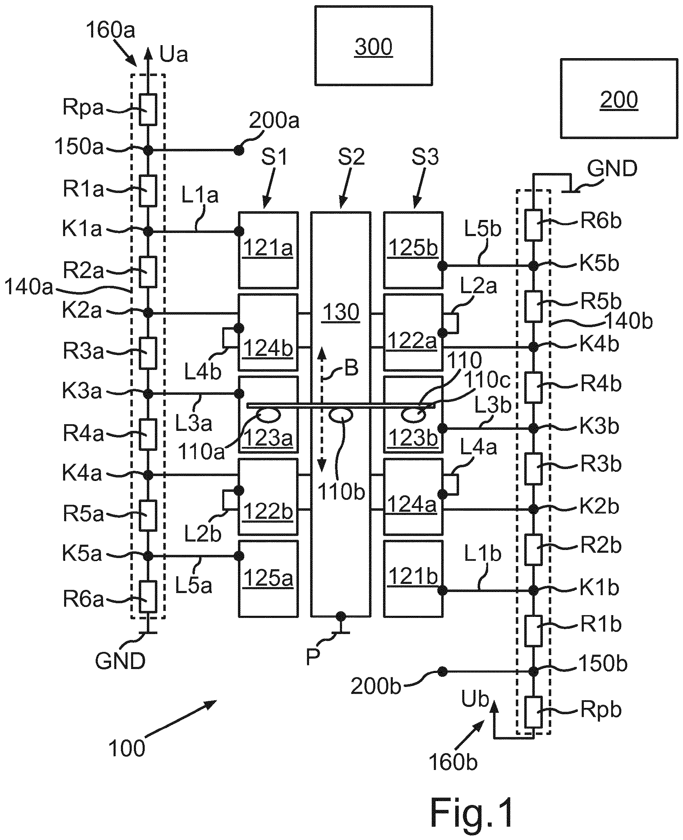

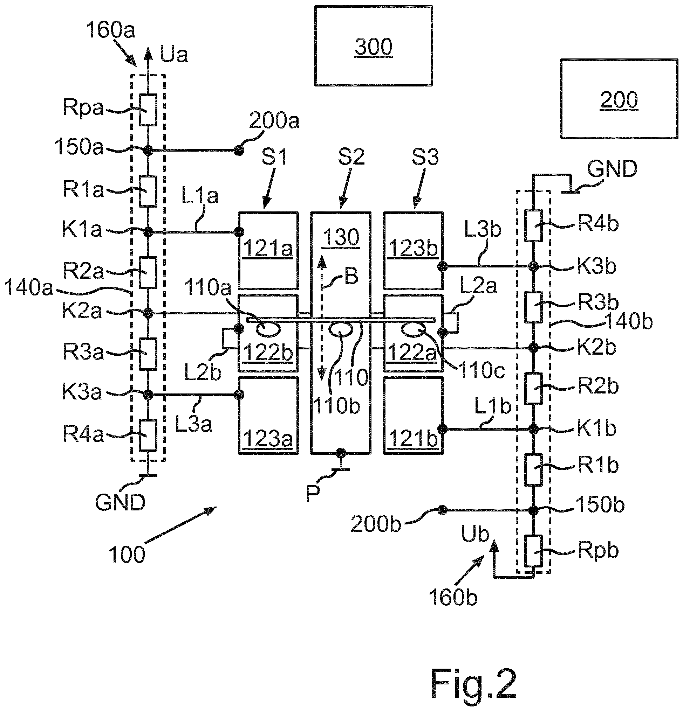

Fig. 1 und Fig. 2 zeigen jeweils eine Schaltungsanordnung 100, welche zur Auswertung verschiedener Schaltzustände eines hier nicht dargestellten Betätigungselementes dient. Das Betätigungselement kann beispielsweise ein Lenkstockschalter eines hier nicht gezeigten Kraftfahrzeugs sein, welcher durch einen Fahrer des Kraftfahrzeugs betätigbar ist. Beispielsweise kann der Lenkstockschalter zur Fahrtrichtungsanzeige dienen, insbesondere zur Betätigung eines Blinkers. Über eine Stellung bzw. einen Zustand eines solchen Betätigungselementes wird durch den Fahrer ein Fahrtrichtungswunsch vorgegeben, welcher durch die anschließende Aktivierung eines entsprechenden Blinkers des Kraftfahrzeugs visualisiert werden soll. Auch kann der Lenkstockschalter zur Betätigung einer Scheibenwischanlage des Kraftfahrzeugs dienen.

In Fig. 1 ist eine Schaltungsanordnung 100 gezeigt, mittels welcher fünf Schaltzustände des Betätigungselementes erfasst werden können. Ein erster Schaltzustand entspricht beispielsweise einem Abbiegewunsch nach links, welcher durch ein dauerhaftes Blinken des linken Blinkers während der Abbiegemanövers visualisiert werden soll. Ein zweiter Schaltzustand entspricht einem Spurwechselwunsch nach links, welcher durch ein kurzzeitiges Blinken des linken Blinkers visualisiert werden soll. Ein dritter Schaltzustand entspricht einem neutralen Zustand, in welchem kein Blinksignal ausgegeben werden soll. Ein vierter Schaltzustand entspricht einem Spurwechselwunsch nach rechts, welcher durch ein kurzzeitiges Blinken des rechten Blinkers visualisiert werden soll. Ein fünfter Schaltzustand entspricht einem Abbiegewunsch nach rechts, welcher durch ein dauerhaftes Blinken des rechten Blinkers während der Abbiegemanövers visualisiert werden soll. In Fig. 2 ist eine Schaltungsanordnung 100 gezeigt, mittels welcher drei Schaltzustände des Betätigungselementes erfasst werden können. Die drei Schaltzustände entsprechen beispielsweise unterschiedliche Stärken bzw. Geschwindigkeiten einer Wischfunktion der Scheibenwischanlage.

Zum Auswerten des Schaltzustandes weist die Schaltungsanordnung 100 hier zwei Auswerteschaltungen 140a, 140b auf, welche hier in Form von Spannungsteilern ausgebildet sind. Es können aber auch mehr Auswerteschaltungen vorgesehen sein. Bei einer ersten Auswerteschaltung 140a sind gemäß Fig. 1 sechs erste Widerstände R1a, R2a, R3a, R4a, R5a, R6a in Reihe geschaltet, wobei zwischen den ersten Widerständen R1a bis R6a erste Knotenpunkte K1a, K2a, K3a, K4a, K5a angeordnet sind. Bei einer zweiten Auswerteschaltung 140b sind sechs zweite Widerstände R1b, R2b, R3b, R4b, R5b, R6b in Reihe geschaltet, wobei zwischen den zweiten Widerständen R1b bis R6b zweite Knotenpunkte K1b, K2b, K3b, K4b, K5b angeordnet sind. Die Auswerteschaltungen 140a, 140b sind elektrisch mit einem Bezugspotential, hier dem Masseanschluss GND, verbunden. Die Serienschaltung aus ersten Widerständen R1a, R2a, R3a, R4a, R5a, R6a der ersten Auswerteschaltung 140a ist über einen ersten Vorwiderstand Rpa mit einer ersten Versorgungsspannung Ua verbunden. Die Serienschaltung aus zweiten Widerständen R1b, R2b, R3b, R4b, R5b, R6b der zweiten Auswerteschaltung 140b ist über einen zweiten Vorwiderstand Rpb mit einer zweiten Versorgungsspannung Ub verbunden.

Zwischen der Serienschaltung der ersten Widerstände R1a, R2a, R3a, R4a, R5a, R6a und dem ersten Vorwiderstand Rpa befindet sich ein erster Abgriff 150a zum Abgreifen eines ersten Ausgangssignals der ersten Auswerteschaltung 140a. Zwischen der Serienschaltung der zweiten Widerstände R1b, R2b, R3b, R4b, R5b, R6b und dem zweiten Vorwiderstand Rpb befindet sich ein zweiter Abgriff 150b zum Abgreifen eines zweiten Ausgangssignals der zweiten Auswerteschaltung 140b. Die ersten und zweiten Ausgangssignale können über jeweilige Analogeingänge 200a, 200b einer Recheneinheit 200 der Schaltungsanordnung 100 erfasst und ausgewertet werden. Auch kann vorgesehen sein, dass die Schaltungsanordnung 100 für jede Auswerteschaltung 140a, 140b eine separate Recheneinheit 200 aufweist.

Ein erstes Ausgangssignal in Form von einer ersten Ausgangsspannung U1 am ersten Analogeingang 200a ergibt sich gemäß der Spannungsteilerregel zu

$$U1 = Ua \cdot \frac{\sum_i Ria}{Rpa + \sum_i Ria}.$$

Ein zweites Ausgangssignal in Form von einer zweiten Ausgangsspannung U2 am zweiten Analogeingang 200b ergibt sich zu

$$U2 = Ub \cdot \frac{\sum_i Rib}{Rpb + \sum_i Rib}.$$

Die Ausgangssignale, also die Ausgangsspannungen U1, U2, der jeweiligen Auswerteschaltung 140a, 140b sind also davon abhängig, wie viele der Widerstände R1a, R2a, R3a, R4a, R5a, R6a bzw. R1b, R2b, R3b, R4b, R5b, R6b miteinander in Serie geschaltet sind. Anders ausgedrückt sind die Ausgangsspannungen U1, U2 davon abhängig, wie viele der Knotenpunkte K1a, K2a, K3a, K4a, K5a bzw. K1b, K2b, K3b, K4b, K5b miteinander und/oder mit einem Bezugspotential P, welches vorzugsweise ebenfalls das Massepotential GND ist, verbunden sind. Zum Verbinden eines der Knotenpunkte K1a bis K5a bzw. K1b bis K5b mit dem Bezugspotential P weist die Schaltungsanordnung 100 ein bewegliches Kontaktmittel 110 auf, welches mit dem Betätigungselement mechanisch verbunden ist und gemeinsam mit dem Betätigungselement entlang eines Verfahrweges des Betätigungselements bewegt werden kann. Das bewegliche Kontaktmittel 110 ist hier als eine mehrpolige Brücke ausgebildet. Eine Bewegung B des Kontaktmittels 110, hier eine lineare Bewegung des Kontaktmittels 110 entlang einer vertikalen Richtung, ist anhand eines Doppelpfeils in Fig. 1 und Fig. 2 visualisiert. Entlang des Verfahrweges sind außerdem Kontaktflächen 121a, 122a, 123a, 124a, 125a, 121b, 122b, 123b, 124b, 125b angeordnet. Dabei ist jeweils eine von ersten Kontaktflächen 121a, 122a, 123a, 124a, 125a mit einem der ersten Knotenpunkte K1a, K2a, K3a, K4a, K5a elektrisch verbunden und eine von zweiten Kontaktflächen 121b, 122b, 123b, 124b, 125b mit einem der zweiten Knotenpunkte K1b, K2b, K3b, K4b, K5b elektrisch verbunden. Außerdem weist die Schaltungsanordnung 100 eine Bezugspotentialfläche 130 auf, welche mit dem Bezugspotential P verbunden ist. Das Bezugspotential P kann beispielsweise das Massepotential GND sein.

Die Kontaktflächen 121a bis 125a, 121b bis 125b sowie die Bezugspotentialfläche 130 sind hier in Spalten S1, S2, S3, beispielsweise auf einer Vorderseite eines Schaltungsträgers, angeordnet. In einer ersten Spalte S1 sind dabei abwechselnd erste Kontaktflächen 121a, 123a, 125a und zweite Kontaktflächen 124b, 122b angeordnet. Eine zweite Spalte S2 wird durch die Bezugspotentialfläche 130 gebildet. In einer dritten Spalte S3 sind abwechselnd zweite Kontaktflächen 125b, 123b, 121b und erste Kontaktflächen 122a, 124a angeordnet. Die erste Auswerteschaltung 140a befindet sich hier linksseitig neben der ersten Spalte S1 auf dem Schaltungsträger, die zweite Auswerteschaltung 140b befindet sich hier rechtsseitig neben der dritten Spalte S3 auf dem Schaltungsträger. Die ersten Kontaktflächen 121a, 123a, 125a der ersten Spalte S1 sind über Leiterbahnen L1a, L3a, L5a mit den jeweiligen ersten Knotenpunkten K1a, K3a, K5a der ersten Auswerteschaltung 140a verbunden und die zweiten Kontaktflächen 121b, 123b, 125b der dritten Spalte S3 sind über Leiterbahnen L1b, L3b, L5b mit den jeweiligen zweiten Knotenpunkten K1b, K3b, K5b der zweiten Auswerteschaltung 140b verbunden, wobei die Leiterbahnen L1a, L3a, L5a, L1b, L3b, L5b insbesondere auf der Vorderseite des Schaltungsträgers angeordnet sind. Die ersten Kontaktflächen 122a, 124a der dritten Spalte S3 sind über Leiterbahnen L2a, L4a mit den ersten Knotenpunkten K2a, K4a der ersten Auswerteschaltung 140a und die zweiten Kontaktflächen 122b, 124b der ersten Spalte S1 sind über Leiterbahnen L2b, L4b mit den zweiten Knotenpunkten K2b, K4b der zweiten Auswerteschaltung 140b verbunden, wobei die Leiterbahnen L2a, L4a, L2b, L4b, beispielsweise über Durchkontaktierungen auf eine Rückseite oder eine Zwischenschicht des Schaltungsträgers geführt sind und von dort aus zu dem jeweiligen Auswerteschaltungen 140a, 140b geführt werden.

Befindet sich das bewegliche Kontaktmittel 110, wie in Fig. 1 gezeigt, in dem dritten, neutralen Schaltzustand, so kontaktiert ein erster Pol 110a des beweglichen Kontaktmittels 110 die erste Kontaktfläche 123a, ein zweiter Pol 110b des Kontaktmittels die Bezugspotentialfläche 130 und ein dritter Pol 110c des Kontaktmittels die zweite Kontaktfläche 123b. Dadurch sind in der ersten Auswerteschaltung 140a die ersten Knotenpunkte K1a, K2a, K3a und damit die ersten Widerstände R1a, R2a, R3a seriell miteinander und über das bewegliche Kontaktmittel 110 mit dem Bezugspotential P verbunden. Die erste Ausgangsspannung U1 ergibt sich also zu

$$U1 = Ua \cdot \frac{R1a+R2a+R3a}{Rpa+R1a+R2a+R3a}.$$

Außerdem sind in der zweiten Auswerteschaltung 140a die zweiten Knotenpunkte K1b, K2b, K3b und damit die zweiten Widerstände R1b, R2b, R3b seriell miteinander und über das bewegliche Kontaktmittel 110 mit dem Bezugspotential P verbunden. Die zweite Ausgangsspannung U2 ergibt sich also zu

$$U2 = Ub \cdot \frac{R1b+R2b+R3b}{Rpb+R1b+R2b+R3b}.$$

In der ersten Schalterstellung hingegen, welche hier über die Bewegung B des Kontaktmittels 110 in vertikaler Richtung nach oben erreicht wird, kontaktiert das Kontaktmittel 110 die erste Kontaktfläche 121a, die Bezugspotentialfläche 130 sowie die zweite Kontaktfläche 125b. Dadurch ist in der ersten Auswerteschaltung 140a der erste Knotenpunkte K1a über das bewegliche Kontaktmittel 110 mit dem Bezugspotential P verbunden. Die erste Ausgangsspannung U1 ergibt sich also zu

$$U1 = Ua \cdot \frac{R1a}{Rpa+R1a}.$$

In der zweiten Auswerteschaltung 140a sind die zweiten Knotenpunkte K1b, K2b, K3b, K4b, K5b und damit die zweiten Widerstände R1b, R2b, R3b, R4b, R5b miteinander und über das bewegliche Kontaktmittel 110 mit dem Bezugspotential P verbunden. Die zweite Ausgangsspannung U2 ergibt sich also zu

$$U2 = Ub \cdot \frac{R1b+R2b+R3b+R4b+R5b}{Rpb+R1b+R2b+R3b+R4b+R5b}.$$

Dementsprechend sind sämtliche weiteren Schalterstellungen zu bestimmen. Ebenso sind die Schalterstellungen des Betätigungselementes gemäß Fig. 2 zu bestimmen, wobei die jeweiligen Auswerteschaltungen 140a, 140b hier jeweils nur vier in Reihe geschaltete Widerstände R1a, R2a, R3a, R4a, R1b, R2b, R3b, R4b aufweisen. Somit ist in jeder Schalterstellung des Kontaktmittels 110 an jedem der Analogeingänge 200a, 200b eine dem jeweiligen Schaltzustand des Betätigungselementes zugeordnete Ausgangsspannung U1, U2 messbar. Anhand eines Wertes der Ausgangsspannungen U1, U2 kann also der Schaltzustand des Betätigungselement bestimmt werden.

Durch die abwechselnde Anordnung der ersten und zweiten Kontaktflächen 121a bis 125a, 121b bis 125b in der ersten und dritten Spalte S1, S3 sowie die Trennung der ersten und dritten Spalte S1, S3 durch die zweite Spalte S2 sind hier niemals zwei Kontaktflächen 121 a bis 125a, 121b bis 125b nebeneinander angeordnet, welche an derselben Auswerteschaltung 140a, 140b angeschlossen sind. Ein Abstand zwischen den mit den Auswerteschaltungen 140a, 140b verbundenen Kontaktflächen 121a bis 125a, 121b bis 125b und der zentralen Bezugspotentialfläche 130 kann beispielsweise bauartbedingt deutlich größer ausgeführt werden als ein Abstand zwischen den mit den Auswerteschaltungen 140a, 140b verbundenen Kontaktflächen 121a bis 125a, 121b bis 125b. Dadurch kann gewährleistet werden, dass kein schwer erkennbarer Schluss zwischen zwei Kontaktflächen 121a bis 125a, 121b bis 125b derselben Auswerteschaltung 140a, 140b auftreten kann.

Hier kann allerdings ein Schluss zwischen den Kontaktflächen 121a bis 125a, 121b bis 125b beider Auswerteschaltungen 140a, 140b auftreten. Um einen solchen Fehler zu detektieren, ist die Schaltungsanordnung 100 zur Fehlerdiagnose ausgelegt. Dazu sind die Auswerteschaltungen 140a, 140b getrennt voneinander anschaltbar und abschaltbar. In einem angeschalteten Zustand ist die jeweilige Auswerteschaltung 140a, 140b dazu ausgelegt, den Schaltzustand des Betätigungselementes zu erfassen. Im abgeschalteten Zustand ist jeweilige Auswerteschaltung 140a, 140b zur Fehlerdiagnose ausgelegt. Beispielsweise ist die erste Auswerteschaltung 140a im angeschalteten Zustand mit der Versorgungsspannung Ua verbunden und im abgeschalteten Zustand von der Versorgungsspannung Ua getrennt. Die zweite Auswerteschaltung 140b ist im angeschalteten Zustand mit der Versorgungsspannung Ub verbunden und im abgeschalteten Zustand von der Versorgungsspannung Ub getrennt.

Dazu können die Auswerteschaltungen 140a, 140b beispielsweise schaltbare Spannungsquellen 160a, 160b aufweisen, über welche die jeweilige Versorgungsspannung Ua, Ub an die jeweilige Auswerteschaltung 140a, 140b angelegt wird. Die separat voneinander schaltbaren Spannungsquellen 160a, 160b sind beispielsweise über eine Steuereinheit 300 der Schaltungsanordnung 100 ansteuerbar. Alternativ dazu kann beispielsweise jeweils eine ansteuerbare Schalteinrichtung zwischen dem Vorwiderstand Rpa, Rpb und der jeweiligen Versorgungsspannung Ua, Ub oder zwischen dem Widerstand R6a, R6b und dem Bezugspotential GND angeschlossen sein. Auch kann vorgesehen sein, dass die Reihenschaltungen R1a bis R6a und R1b bis R6b jeweils direkt an eine schaltbare Stromquelle angeschlossen sind.

In einem Beispiel befindet sich das bewegliche Kontaktmittel 110 in der in Fig. 1 gezeigten dritten Schalterstellung und beide Versorgungsspannungen Ua, Ub -und damit beide Auswerteschaltungen 140a, 140b- sind eingeschaltet. Tritt nun ein Schluss, also ein Kurzschluss oder ein anderer parasitärer, niederohmiger Übergangswiderstand, zwischen der ersten Kontaktfläche 121a und der zweiten Kontaktfläche 124b in der ersten Spalte S1 auf, so wird sich eine Spannungsdifferenz zwischen den beiden Kontaktflächen 121a und 124b verringern (sofern die Differenz nicht bereits vorher durch entsprechende Widerstände in den beiden Auswerteschaltungen 140a, 140b gleich null war). Kommt es nun zu einer Verringerung der Spannungsdifferenz zwischen den beiden Kontaktflächen 121a, 124b, führt dies auch zu einer Veränderung der Spannungsverhältnisse in den beiden Auswerteschaltungen 140a, 140b. Dies wiederum führt zu einer Änderung der jeweiligen Ausgangsspannungen U1, U2 an den Analogeingängen 200a, 200b der Recheneinheit 200. Dabei kann es vorkommen, dass die Veränderung der Ausgangsspannungen U1, U2 entweder zu gering ist, um eine Erkennungsschwelle zu erreichen, oder dass die Veränderung gar zu einem plausiblen Gesamtzustand führt. Dies bedeutet beispielsweise, dass die Ausgangsspannungen U1, U2 einen Wert aufweisen, welcher zwar nicht mit dem Spannungswert der tatsächlichen Schalterstellung korrespondiert, jedoch mit einem zu einer anderen Schalterstellung korrespondierenden Spannungswert korrespondiert. Die Schalterstellung wird also fehlerhaft ausgewertet.

Wird nun die Versorgungsspannung Ub an der zweiten Auswerteschaltung 140b, beispielsweise von der Steuereinheit 300, ausgeschaltet, so verändern sich die Spannungsverhältnisse erneut. Die Veränderung der ersten Ausgangsspannung U1 am ersten Analogeingang 200a kann beispielsweise wiederum relativ gering sein. Die durch den Schluss verursachte Änderung der zweiten Ausgangsspannung U2 an dem zweiten Analogeingang 200b ist jedoch groß und leicht erkennbar, denn ohne den Schluss wäre die Ausgangsspannung U2 im abgeschalteten Zustand der Versorgungsspannung Ub gleich null. Da bedingt durch den Schluss zwischen den Kontaktflächen 121a und 124b jedoch eine Verbindung zur spannungsführenden ersten Auswerteschaltung 140a besteht, ist die zweite Ausgangsspannung U2 deutlich von null verschieden. Entsprechendes gilt für den umgekehrten Fall, also wenn die Versorgungsspannung Ub angeschaltet und die Versorgungsspannung Ua der ersten Auswerteschaltung 140a ausgeschaltet ist.

Durch entsprechende Wahl der Widerstände R1a bis R6a sowie R1b bis R6b kann erreicht werden, dass nahezu alle Schlüsse zwischen benachbarten Kontaktflächen 121a bis 125a, 121b bis 125b eindeutig erkannt werden können, solange der durch den Schluss verursachte Übergangswiderstand klein genug ist, um die Auswertung in einem der möglichen Schaltzustände stören zu können.

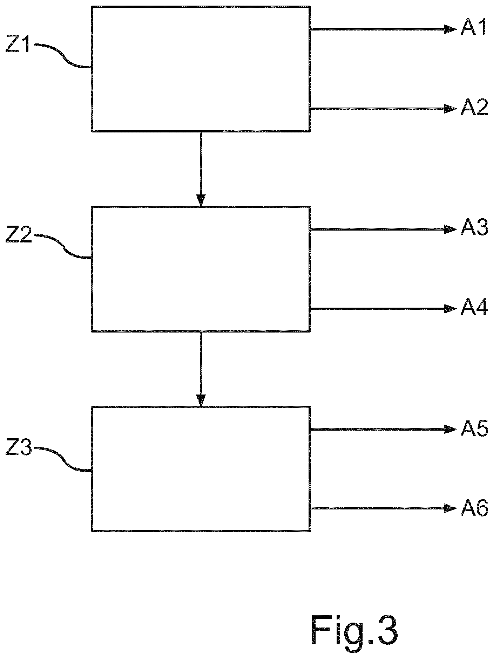

Vorzugsweise können bei jeder Erfassung eines Schaltzustandes des Betätigungselementes verschiedene Schaltzyklen Z1, Z2, Z3 der Schaltungsanordnung 100 durchgeführt werden, wie sie in Fig.3 gezeigt sind. Dazu werden in einem ersten Schaltzyklus Z1 der Schaltungsanordnung 100 beide Auswerteschaltungen 140a, 140b, also beispielsweise beide Versorgungsspannungen Ua, Ub, angeschaltet. Dabei wird von der ersten Auswerteschaltung 140a ein erstes Ausgangssignal A1 und von der zweiten Ausgangsschaltung 140b ein zweites Ausgangssignal A2 erfasst. In einem zweiten Schaltzyklus Z2 wird die Versorgungsspannung Ua angeschaltet und die Versorgungsspannung Ub abgeschaltet, wobei von der angeschalteten ersten Auswerteschaltung 140a ein drittes Ausgangssignal A3 und von der abgeschalteten zweiten Auswerteschaltung 140b ein viertes Ausgangssignal A4 erfasst wird. In einem dritten Schaltzyklus Z3 wird die Versorgungsspannung Ua abgeschaltet und die Versorgungsspannung Ub angeschaltet. Von der abgeschalteten ersten Auswerteschaltung 140a wird ein fünftes Ausgangssignal A5 und von der angeschalteten zweiten Auswerteschaltung 140b wird ein sechstes Ausgangssignal A6 erfasst.

Nun kann ein dreistufiger Plausibilisierungszyklus durchlaufen werden. In einer ersten Stufe werden dabei alle Ausgangssignale A1 bis A6 separat und unabhängig voneinander ausgewertet. Dies bedeutet hier, dass überprüft wird, ob die Ausgangssignale A4, A5 welche zur Fehlerdiagnose verwendet werden, jeweils null sind bzw. höchsten einen vorbestimmten Schwellwert von null abweichen. Die Ausgangssignale A1, A2, A3, A6 welche zur Erfassung des Schaltzustandes dienen, werden dahingehend überprüft, ob sie jeweils plausible Spannungswerte aufweisen, welche zu einem möglichen gültigen Schaltzustand korrespondieren.

In einer zweiten Stufe werden die Ausgangssignale A1 bis A6 beider Auswerteschaltungen 140a, 140b gegeneinander abgeglichen. Dies bedeutet, dass insbesondere überprüft wird, ob das erste Ausgangssignal A1 und das zweite Ausgangssignal A2 auf den gleichen Schaltzustand hindeuten, also ob die Ausgangsspannung des ersten Ausgangssignals A1 und die Ausgangsspannung des zweiten Ausgangssignals A2 demselben Schaltzustand zugeordnet werden können. Außerdem werden das dritte Ausgangssignal A3 und das sechste Ausgangssignal A6 verglichen und überprüft, ob auch diese auf denselben Schaltzustand hindeuten.

In einer dritten Stufe werden dann die Ergebnisse der Schaltzyklen Z1, Z2, Z3 miteinander verglichen, also ob die erste Auswerteschaltung 140a in ihren angeschalteten Zuständen und die zweite Auswerteschaltung 140b in ihren angeschalteten Zuständen denselben Schaltzustand auswerten. Dazu werden beispielsweise das erste Ausgangssignal A1 und das dritte Ausgangssignal A3 sowie das zweite Ausgangssignal A2 und das sechste Ausgangssignal A6 miteinander verglichen. Somit kann der Schaltzustand auf besonders zuverlässige Weise bestimmt werden.

Dabei kann vorgesehen sein, dass eine Toleranzzeit vorgeben wird, innerhalb welcher das Ergebnis der Auswertung des Schaltzustandes vorliegen soll. Wenn die Recheneinheit 200 dazu ausgelegt ist, die drei Stufen der Plausibilisierung innerhalb dieses Toleranzzeit durchzuführen, dann wird der Schaltzustand erst bestimmt, wenn alle drei Stufen durchlaufen sind. Andernfalls kann beispielsweise zuerst der erste Schaltzyklus Z1 durchgeführt werden, anhand dessen der Schaltzustand bereits bestimmt werden kann. Der dort bestimmte Schaltzustand kann dann bereits kommuniziert werden. Der zweite und dritte Schaltzyklus Z2, Z3 können anschließend durchgeführt werden. Auch können beispielsweise nur der zweite und der dritte Schaltzyklus Z2 und Z3 durchgeführt werden.

**Patentansprüche**

1. Schaltungsanordnung (100) zur Auswertung von zumindest zwei Schaltzuständen eines Betätigungselementes, aufweisend

    - ein bewegbares, mit dem Betätigungselement verbindbares Kontaktmittel (110),
    - eine erste Auswerteschaltung (140a) mit einem ersten Spannungsteiler, welcher erste Kontenpunkte (K1a, K2a, K3a, K4a, K5a) sowie einen ersten Abgriff (150a) zum Abgreifen eines ersten Ausgangssignals (A1, A3, A5) der ersten Auswerteschaltung (140a) aufweist,
    - zumindest eine zweite Auswerteschaltung (140b) mit einem zweiten Spannungsteiler, welcher zweite Kontenpunkte (K1b, K2b, K3b, K4b, K5b) sowie einen zweiten Abgriff (150a) zum Abgreifen eines zweiten Ausgangssignals (A2, A4, A6) der zweiten Auswerteschaltung (140b) aufweist,
    - erste Kontaktflächen (121a, 122a, 123a, 124a, 125a), welche jeweils mit einem der ersten Knotenpunkte (K1a bis K5a) elektrisch verbunden sind, und
    - zweite Kontaktflächen (121b, 122b, 123b, 124b, 125b), welche jeweils mit einem der zweiten Knotenpunkte (K1b bis K5b) elektrisch verbunden sind,
    - wobei über das bewegbare Kontaktmittel (110) in Abhängigkeit von dem Schaltzustand des Betätigungselementes zumindest eine der ersten Kontaktflächen (121 a bis 125a) und/oder zumindest eine der zweiten Kontaktflächen (121b bis 125b) mit einem vorbestimmten Bezugspotential (P) elektrisch verbindbar sind, **dadurch gekennzeichnet, dass**

    die Auswerteschaltungen (140a, 140b) separat voneinander anschaltbar und abschaltbar ausgebildet sind, wobei die Schaltungsanordnung (100) dazu ausgelegt ist, anhand des Ausgangssignals (A1 bis A6) einer angeschalteten Auswerteschaltung (140a, 140b) den Schaltzustand des Betätigungselementes zu erfassen und anhand des Ausgangssignals (A1 bis A6) einer abgeschalteten Auswerteschaltung (140a, 140b) eine Fehlerdiagnose der Schaltungsanordnung (100) durchzuführen.

2. Schaltungsanordnung (100) nach Anspruch 1, **dadurch gekennzeichnet, dass**
    die Schaltungsanordnung (100) zumindest eine Recheneinheit (200) aufweist, welche dazu ausgelegt ist, die Ausgangssignale (A1, A2, A3, A4, A5, A6) der Auswerteschaltungen (140a, 140b) auszuwerten, und die Schaltungsanordnung (100) zumindest eine Steuereinheit (300) aufweist, welche dazu ausgelegt ist, die Auswerteschaltungen (140a, 140b) separat voneinander zu schalten.

3. Schaltungsanordnung (100) nach Anspruch 1 oder 2, **dadurch gekennzeichnet, dass**
    die Schaltungsanordnung (100) zum Schalten der Auswerteschaltungen (140a, 140b) zumindest zwei schaltbare Energiequellen (160a, 160b) zum Bereitstellen einer Energieversorgung für die Auswerteschaltungen (140a, 140b) aufweist, wobei die erste Auswerteschaltung (140a) mit einer ersten der schaltbaren Energiequellen (160a) elektrisch verbunden ist und die zumindest eine zweite Auswerteschaltung (140b) mit einer zweiten der schaltbaren Energiequellen (160b) elektrisch verbunden ist.

4. Schaltungsanordnung (100) nach Anspruch 3, **dadurch gekennzeichnet, dass**

die Spannungsteiler über einen jeweiligen Vorwiderstand mit jeweils einer als schaltbare Spannungsquelle ausgebildeten Energiequelle (160a, 160b) zum Bereitstellen einer Versorgungsspannung (Ua, Ub) für die Auswerteschaltungen (140a, 140b) oder die Spannungsteiler direkt mit jeweils einer als schaltbare Stromquelle ausgebildeten Energiequelle (160a, 160b) elektrisch verbunden sind.

5. Schaltungsanordnung (100) nach einem der vorhergehenden Ansprüche,
**dadurch gekennzeichnet, dass**
die Schaltungsanordnung (100) zum Schalten der Auswerteschaltungen (140a, 140b) zumindest zwei steuerbare Schalteinrichtungen aufweist, wobei die erste Auswerteschaltung (140a) mit einer ersten der steuerbaren Schalteinrichtungen zum Schalten der ersten Auswerteschaltung (140a) an einen Versorgungsanschluss (Ua, Ub, GND) elektrisch verbunden ist, und die zumindest eine zweite Auswerteschaltung (140b) mit einer zweiten der steuerbaren Schalteinrichtungen zum Schalten der zweiten Auswerteschaltung (140b) an einen Versorgungsanschluss (Ua, Ub, GND) elektrisch verbunden ist.

6. Schaltungsanordnung (100) nach einem der vorhergehenden Ansprüche,
**dadurch gekennzeichnet, dass**
die Schaltungsanordnung (100) eine mit einer Anzahl an zu erfassenden Schaltzuständen korrespondierende Anzahl an ersten Kontaktflächen (121a bis 125a) und eine mit der Anzahl an zu erfassenden Schaltzuständen korrespondierende Anzahl an zweiten Kontaktflächen (121b bis 125b) aufweist.

7. Schaltungsanordnung (100) nach einem der vorhergehenden Ansprüche,
**dadurch gekennzeichnet, dass**
das bewegliche Kontaktmittel (110) als eine mehrpolige Brücke ausgebildet ist, welche dazu ausgelegt ist, in Abhängigkeit von dem Schaltzustand des Betätigungselementes zumindest eine der ersten Kontaktflächen (121a bis 125a) und/oder zumindest eine der zweiten Kontaktflächen (121b bis 125b) mit dem Bezugspotential (P) elektrisch zu verbinden.

8. Schaltungsanordnung (100) nach Anspruch 7,
**dadurch gekennzeichnet, dass**
die mehrpolige Brücke drei Pole (110a, 110b, 110c) aufweist, wobei in Abhängigkeit von dem Schaltzustand des Betätigungselementes ein erster Pol (110a) mit einer der ersten Kontaktflächen (121a bis 125a), ein zweiter Pol (110b) mit einer mit dem Bezugspotential (P) verbundenen Bezugspotentialfläche (130) und ein dritter Pol (110c) mit einer der zweiten Kontaktflächen (121b bis 125b) elektrisch verbindbar ist.

9. Schaltungsanordnung (100) nach einem der vorhergehenden Ansprüche,
**dadurch gekennzeichnet, dass**
die ersten und zweiten Kontaktflächen (121a bis 125a, 121b bis 125b) in sich entlang eines Verfahrweges des beweglichen Kontaktmittels (110) erstreckenden Spalten (S1, S3) auf einem gemeinsamen Schaltungsträger angeordnet sind, wobei in einer ersten Spalte (S1) abwechselnd erste und zweite Kontaktflächen (121a, 123a, 125a, 124b, 122b) und in einer zweiten Spalte (S3) abwechselnd zweite und erste Kontaktflächen (125b, 123b, 121b, 122a, 124a) angeordnet sind.

10. Schaltungsanordnung (100) nach Anspruch 9,
**dadurch gekennzeichnet, dass**
auf dem gemeinsamen Schaltungsträger zwischen der ersten und der zweiten Spalte (S1, S3) eine sich entlang des Verfahrweges erstreckende dritte Spalte (S2) aufweisend eine mit dem Bezugspotential (P) verbundene Bezugspotentialfläche (130) angeordnet ist.

11. Verfahren zum Betreiben einer Schaltungsanordnung (100) nach einem der vorhergehenden Ansprüche,
**dadurch gekennzeichnet, dass**
während der Erfassung des Schaltzustandes des Betätigungselementes zumindest zwei Schaltzyklen (Z2, Z3) durchgeführt werden, wobei

- in einem ersten Schaltzyklus (Z2) die erste Auswerteschaltung (140a) angeschaltet und die zweite Auswerteschaltung (140b) abgeschaltet wird, und durch die erste Auswerteschaltung (140a) ein erstes Ausgangssignal (A3) und durch die zweite Auswerteschaltung (140b) ein zweites Ausgangssignal (A4) erfasst wird,
- in einem zweiten Schaltzyklus (Z3) die erste Auswerteschaltung (140a) abgeschaltet und die zweite Auswerteschaltung (140b) angeschaltet wird, und durch die erste Auswerteschaltung ein drittes Ausgangssignal (A5) und durch die zweite Auswerteschaltung (140b) ein viertes Ausgangssignal (A6) erfasst wird,
- der Schaltzustand anhand der vier Ausgangssignale (A3, A4, A5, A6) bestimmt wird.

12. Verfahren nach Anspruch 11,
**dadurch gekennzeichnet, dass**
während der Erfassung des Schaltzustandes des Betätigungselementes zumindest ein dritter Schaltzyklus (Z1) durchgeführt wird, in welchem die erste und die zweite Auswerteschaltung (140a, 140b) zeitgleich angeschaltet werden, wobei durch die erste Auswerteschaltung (140a) ein fünftes Ausgangssignal (A1) erfasst wird und durch die zweite Auswerteschaltung (140b) ein sechstes Ausgangssignal (A2) erfasst wird, wobei der Schaltzustand anhand der sechs Ausgangssignale (A1, A2, A3, A4, A5, A6) bestimmt wird.

**13.** Verfahren nach Anspruch 11 oder 12,
**dadurch gekennzeichnet, dass**
zum Überprüfen des Schaltzustandes des Betätigungselementes ein dreistufiger Plausibilisierungszyklus durchlaufen wird, wobei

- in einer ersten Stufe jedes Ausgangssignal (A1, A2, A3, A4, A5, A6) separat plausibilisiert wird,
- in einer zweiten Stufe die miteinander korrespondierenden Ausgangssignale (A1, A2, A3, A4, A5, A6) der zumindest zwei Auswerteschaltungen (140a, 140b) miteinander verglichen und plausibilisiert werden, und
- in einer dritten Stufe die Ausgangssignale (A1, A2, A3, A4, A5, A6) der jeweiligen Schaltzyklen (Z1, Z2, Z3) miteinander verglichen und plausibilisiert werden.

**14.** Schaltvorrichtung aufweisend ein Betätigungselement sowie eine Schaltungsanordnung (100) nach einem der Ansprüche 1 bis 10, wobei das bewegliche Kontaktmittel (110) der Schaltungsanordnung (100) mit dem Betätigungselement verbunden ist.

**Claims**

**1.** Circuit arrangement (100) for evaluating at least two switching states of an actuating element, having

- a moveable contact means (110) which is connectable to the actuating element,
- a first evaluation circuit (140a) with a first voltage divider, which has first node points (K1a, K2a, K3a, K4a, K5a) and a first tap (150a) for tapping off a first output signal (A1, A3, A5) of the first evaluation circuit (140a),
- at least one second evaluation circuit (140b) with a second voltage divider, which has second node points (K1b, K2b, K3b, K4b, K5b) and a second tap (150a) for tapping off a second output signal (A2, A4, A6) of the second evaluation circuit (140b),
- first contact surfaces (121a, 122a, 123a, 124a, 125a), which are each electrically connected to one of the first node points (K1a to K5a), and
- second contact surfaces (121b, 122b, 123b, 124b, 125b), which are each electrically connected to one of the second node points (K1b to K5b),
- wherein via the movable contact means (110), depending on the switching state of the actuating element at least one of the first contact surfaces (121a to 125a) and/or at least one of the second contact surfaces (121b and 125b) are electrically connectable to a predetermined reference potential (P),

**characterized in that**
the evaluation circuits (140a, 140b) are designed to be switched on and off separately from each other, wherein the circuit arrangement (100) is designed to detect the switching state of the actuating element on the basis of the output signal (A1 to A6) of a connected evaluation circuit (140a, 140b) and on the basis of the output signal (A1 to A6) of a deactivated evaluation circuit (140a, 140b) to carry out a fault diagnosis of the circuit arrangement (100).

**2.** Circuit arrangement (100) according to Claim 1,
**characterized in that**
the circuit arrangement (100) has at least one processing unit (200) which is designed to evaluate the output signals (A1, A2, A3, A4, A5, A6) of the evaluation circuits (140a, 140b), and the circuit arrangement (100) has at least one control unit (300) which is designed to switch the evaluation circuits (140a, 140b) separately from each other.

**3.** Circuit arrangement (100) according to Claim 1 or 2,
**characterized in that**
the circuit arrangement (100) for switching the evaluation circuits (140a, 140b) has at least two switchable energy sources (160a, 160b) to provide an energy supply for the evaluation circuits (140a, 140b), wherein the first evaluation circuit (140a) is electrically connected to a first of the switchable energy sources (160a) and the at least one second evaluation circuit (140b) is electrically connected to a second of the switchable energy sources (160b) .

**4.** Circuit arrangement (100) according to Claim 3,
**characterized in that**
the voltage dividers are each connected via a respective series resistor to an energy source (160a, 160b) designed as a switchable voltage source to provide a supply voltage (Ua, Ub) for the evaluation circuits (140a, 140b), or the voltage dividers are each directly electrically connected to an energy source (160a, 160b) designed as a switchable current source.

**5.** Circuit arrangement (100) according to any one of the preceding claims,
**characterized in that**
the circuit arrangement (100) has at least two controllable switching devices for switching the evaluation circuits (140a, 140b), wherein the first evaluation circuit (140a) is electrically connected to a first of the controllable switching devices for switching the first evaluation circuit (140a) to a supply terminal (Ua, Ub, GND), and the at least one second evaluation circuit (140b) is electrically connected to a second of the controllable switching devices for switching the second evaluation circuit (140b) to a supply terminal (Ua, Ub, GND).

6.  Circuit arrangement (100) according to any one of the preceding claims, **characterized in that** the circuit arrangement (100) has a number of first contact surfaces (121a to 125a) corresponding to a number of switching states to be detected, and a number of second contact surfaces (121b to 125b) corresponding to the number of switching states to be detected.

7.  Circuit arrangement (100) according to any one of the preceding claims, **characterized in that** the movable contact means (110) is designed as a multi-pole bridge, which is designed to electrically connect at least one of the first contact surfaces (121a to 125a) and/or at least one of the second contact surfaces (121b to 125b) to the reference potential (P) depending on the switching state of the actuating element.

8.  Circuit arrangement (100) according to Claim 7, **characterized in that** the multi-pole bridge has three poles (110a, 110b, 110c), wherein depending on the switching state of the actuating element a first pole (110a) is electrically connectable to one of the first contact surfaces (121a to 125a), a second pole (110b) is electrically connectable to a reference potential surface (130) connected to the reference potential (P), and a third pole (110c) is electrically connectable to one of the second contact surfaces (121b to 125b).

9.  Circuit arrangement (100) according to any one of the preceding claims, **characterized in that** the first and second contact surfaces (121a to 125a, 121b to 125b) are arranged on a common circuit substrate in columns (S1, S3) that extend along a travel path of the movable contact means (110), wherein in a first column (S1) alternating first and second contact surfaces (121a, 123a, 125a, 124b, 122b) and in a second column (S3) alternating second and first contact surfaces (125b, 123b, 121b, 122a, 124a) are arranged.

10.  Circuit arrangement (100) according to Claim 9, **characterized in that** on the common circuit substrate between the first and the second column (S1, S3) a third column (S2) is arranged, which extends along the travel path and has a reference potential surface (130) connected to the reference potential (P).

11.  Method for operating a circuit arrangement (100) according to any one of the preceding claims, **characterized in that** during the detection of the switching state of the actuating element at least two switching cycles (Z2, Z3) are carried out, wherein

- in a first switching cycle (Z2) the first evaluation circuit (140a) is switched on and the second evaluation circuit (140b) is switched off, and a first output signal (A3) is detected by the first evaluation circuit (140a) and a second output signal (A4) is detected by the second evaluation circuit (140b),
- in a second switching cycle (Z3) the first evaluation circuit (140a) is switched off and the second evaluation circuit (140b) is switched on, and a third output signal (A5) is detected by the first evaluation circuit and a fourth output signal (A6) is detected by the second evaluation circuit (140b),
- the switching state is determined on the basis of the four output signals (A3, A4, A5, A6).

12.  Method according to Claim 11, **characterized in that** during the detection of the switching state of the actuating element, at least one third switching cycle (Z1) is carried out, in which the first and the second evaluation circuit (140a, 140b) are switched on at the same time, wherein a fifth output signal (A1) is detected by the first evaluation circuit (140a) and a sixth output signal (A2) is detected by the second evaluation circuit (140b), wherein the switching state is determined on the basis of the six output signals (A1, A2, A3, A4, A5, A6).

13.  Method according to Claim 11 or 12, **characterized in that** in order to check the switching state of the actuating element a three-stage validation cycle is executed, wherein

- in a first stage, each output signal (A1, A2, A3, A4, A5, A6) is validated separately,
- in a second stage the output signals (A1, A2, A3, A4, A5, A6) corresponding to each other of the at least two evaluation circuits (140a, 140b) are compared with each other and validated, and
- in a third stage the output signals (A1, A2, A3, A4, A5, A6) of the respective switching cycles (Z1, Z2, Z3) are compared with each other and validated.

14.  Switching device having an actuating element, and a circuit arrangement (100) according to any one of Claims 1 to 10, the movable contact means (110) of the circuit arrangement (100) being connected to the actuating element.

## Revendications

**1.** Agencement de circuit (100) destiné à évaluer au moins deux états de commutation d'un élément d'actionnement, comportant

- un moyen de contact mobile (110) pouvant être relié à l'élément d'actionnement,
- un premier circuit d'évaluation (140a) comportant un premier diviseur de tension, qui comporte des premiers points nodaux (K1a, K2a, K3a, K4a, K5a) ainsi qu'une première prise (150a) destinée à prélever un premier signal de sortie (A1, A3, A5) du premier circuit d'évaluation (140a),
- au moins un deuxième circuit d'évaluation (140b) comportant un deuxième diviseur de tension, qui comporte des deuxièmes points nodaux (K1b, K2b, K3b, K4b, K5b) et une deuxième prise (150a) destinée à prélever un deuxième signal de sortie (A2, A4, A6) du deuxième circuit d'évaluation (140b),
- des premières surfaces de contact (121a, 122a, 123a, 124a, 125a), qui sont respectivement reliées électriquement à l'un des premiers points nodaux (K1a à K5a), et
- des deuxièmes surfaces de contact (121b, 122b, 123b, 124b, 125b), qui sont respectivement reliées électriquement à l'un des deuxièmes points nodaux (K1b à K5b),
- dans lequel au moins l'une des premières surfaces de contact (121a à 125a) et/ou au moins l'une des deuxièmes surfaces de contact (121b à 125b) peuvent être reliées électriquement à un potentiel de référence prédéterminé (P) par l'intermédiaire du moyen de contact mobile (110) en fonction de l'état de commutation de l'élément d'actionnement,

**caractérisé en ce que** les circuits d'évaluation (140a, 140b) sont conçus de telle sorte qu'ils peuvent être activés et désactivés séparément les uns des autres, dans lequel l'agencement de circuit (100) est conçu pour détecter l'état de commutation de l'élément d'actionnement sur la base du signal de sortie (A1 à A6) d'un circuit d'évaluation activé (140a, 140b) et pour effectuer un diagnostic de défaut de l'agencement de circuit (100) sur la base du signal de sortie (A1 à A6) d'un circuit d'évaluation désactivé (140a, 140b).

**2.** Agencement de circuit (100) selon la revendication 1,
**caractérisé en ce que** l'agencement de circuit (100) comporte au moins une unité de calcul (200) qui est conçue pour évaluer les signaux de sortie (A1, A2, A3, A4, A5, A6) des circuits d'évaluation (140a, 140b), et l'agencement de circuit (100) comporte au moins une unité de commande (300) qui est conçue pour commuter les circuits d'évaluation (140a, 140b) séparément les uns des autres.

**3.** Agencement de circuit (100) selon la revendication 1 ou 2,
**caractérisé en ce que** l'agencement de circuit (100) comporte, pour la commutation des circuits d'évaluation (140a, 140b), au moins deux sources d'énergie commutables (160a, 160b) destinées à assurer une alimentation en énergie des circuits d'évaluation (140a, 140b), dans lequel le premier circuit d'évaluation (140a) est relié électriquement à une première des sources d'énergie commutables (160a) et ledit au moins un deuxième circuit d'évaluation (140b) est relié électriquement à une deuxième des sources d'énergie commutables (160b).

**4.** Agencement de circuit (100) selon la revendication 3,
**caractérisé en ce que** les diviseurs de tension sont reliés électriquement par l'intermédiaire d'une résistance série respective à une source d'énergie (160a, 160b) respective réalisée sous la forme d'une source de tension commutable et destinée à fournir une tension d'alimentation (Ua, Ub) pour les circuits d'évaluation (140a, 140b) ou les diviseurs de tension sont directement reliés électriquement à une source d'énergie (160a, 160b) respective réalisée sous la forme d'une source de courant commutable.

**5.** Agencement de circuit (100) selon l'une des revendications précédentes,
**caractérisé en ce que** l'agencement de circuit (100) comporte au moins deux dispositifs de commutation commandables destinés à commuter les circuits d'évaluation (140a, 140b), dans lequel le premier circuit d'évaluation (140a) est relié électriquement à un premier des dispositifs de commutation commandables pour commuter le premier circuit d'évaluation (140a) au niveau d'une borne d'alimentation (Ua, Ub, GND),
et ledit au moins un deuxième circuit d'évaluation (140b) est relié électriquement à un deuxième des dispositifs de commutation commandables pour commuter le deuxième circuit d'évaluation (140b) au niveau d'une borne d'alimentation (Ua, Ub, GND).

**6.** Agencement de circuit (100) selon l'une des revendications précédentes,
**caractérisé en ce que** l'agencement de circuit (100) comporte un nombre de premières surfaces de contact (121a à 125a) qui correspond à un nombre d'états de commutation à détecter, et un nombre de deuxièmes surfaces de contact (121b à 125b) qui correspond au nombre d'états de commutation à détecter.

7. Agencement de circuit (100) selon l'une des revendications précédentes, **caractérisé en ce que** le moyen de contact mobile (110) est réalisé sous la forme d'un pont multipolaire qui est conçu pour relier électriquement au moins l'une des premières surfaces de contact (121a à 125a) et/ou au moins l'une des deuxièmes surfaces de contact (121b à 125b) au potentiel de référence (P) selon l'état de commutation de l'élément d'actionnement.

8. Agencement de circuit (100) selon la revendication 7, **caractérisé en ce que** le pont multipolaire comporte trois pôles (110a, 110b, 110e), dans lequel, selon l'état de commutation de l'élément d'actionnement, un premier pôle (110a) peut être relié électriquement à l'une des premières surfaces de contact (121a à 125a), un deuxième pôle (110b) peut être relié électriquement à une surface de potentiel de référence (130) qui est reliée au potentiel de référence (P), et un troisième pôle (110e) peut être relié électriquement à l'une des deuxièmes surfaces de contact (121b à 125b).

9. Agencement de circuit (100) selon l'une des revendications précédentes, **caractérisé en ce que** les premières et deuxièmes surfaces de contact (121a à 125a, 121b à 125b) sont agencées sur un support de circuit commun en colonnes (S1, S3) s'étendant le long d'un trajet de déplacement du moyen de contact mobile (110), dans lequel les premières et deuxièmes surfaces de contact (121a, 123a, 125a, 124b, 122b) sont agencées en alternance dans une première colonne (S1) et les deuxièmes et premières surfaces de contact (125b, 123b, 121b, 122a, 124a) sont agencées en alternance dans une deuxième colonne (S3).

10. Agencement de circuit (100) selon la revendication 9, **caractérisé en ce qu'**une troisième colonne (S2) s'étendant le long du trajet de déplacement et présentant une surface de potentiel de référence (130) qui est reliée au potentiel de référence (P) est agencée sur le support de circuit commun entre les première et deuxième colonnes (S1, S3).

11. Procédé de fonctionnement d'un agencement de circuit (100) selon l'une des revendications précédentes, **caractérisé en ce qu'**au moins deux cycles de commutation (Z2, Z3) sont effectués pendant la détection de l'état de commutation de l'élément d'actionnement, dans lequel

- dans un premier cycle de commutation (Z2), le premier circuit d'évaluation (140a) est activé et le deuxième circuit d'évaluation (140b) est désactivé, et un premier signal de sortie (A3) est détecté par le premier circuit d'évaluation (140a) et un deuxième signal de sortie (A4) est détecté par le deuxième circuit d'évaluation (140b),
- dans un deuxième cycle de commutation (Z3), le premier circuit d'évaluation (140a) est désactivé et le deuxième circuit d'évaluation (140b) est activé, et un troisième signal de sortie (A5) est détecté par le premier circuit d'évaluation et un quatrième signal de sortie (A6) est détecté par le deuxième circuit d'évaluation (140b),
- l'état de commutation est déterminé sur la base des quatre signaux de sortie (A3, A4, A5, A6).

12. Procédé selon la revendication 11, **caractérisé en ce que**, pendant la détection de l'état de commutation de l'élément d'actionnement, au moins un troisième cycle de commutation (Z1) est effectué, au cours duquel les premier et deuxième circuits d'évaluation (140a, 140b) sont activés simultanément, dans lequel un cinquième signal de sortie (A1) est détecté par le premier circuit d'évaluation (140a) et un sixième signal de sortie (A2) est détecté par le deuxième circuit d'évaluation (140b), dans lequel l'état de commutation est déterminé sur la base des six signaux de sortie (A1, A2, A3, A4, A5, A6).

13. Procédé selon la revendication 11 ou 12, **caractérisé en ce que**, pour vérifier l'état de commutation de l'élément d'actionnement, un cycle de test de plausibilité en trois étapes est effectué, dans lequel

- dans une première étape, chaque signal de sortie (A1, A2, A3, A4, A5, A6) est soumis séparément à un test de plausibilité,
- dans une deuxième étape, les signaux de sortie (A1, A2, A3, A4, A5, A6) desdits au moins deux circuits d'évaluation (140a, 140b) mutuellement correspondants sont comparés les uns aux autres et soumis à un test de plausibilité, et
- dans une troisième étape, les signaux de sortie (A1, A2, A3, A4, A5, A6) des cycles de commutation respectifs (Z1, Z2, Z3) sont comparés les uns aux autres et soumis à un test de plausibilité.

14. Dispositif de commutation comportant un élément d'actionnement ainsi qu'un circuit (100) selon l'une des revendications 1 à 10, dans lequel le moyen de contact mobile (110) de l'agencement de circuit (100) est relié à l'élément d'actionnement.

Fig.1

Fig.2

Fig.3

**IN DER BESCHREIBUNG AUFGEFÜHRTE DOKUMENTE**

**In der Beschreibung aufgeführte Patentdokumente**

- DE 102009056283 A1
- WO 20080173511 A1